# EUROPEAN PATENT APPLICATION

(11) **EP 4 815 221 A1**
(43) Date of publication of application: **30.09.2026**
(21) Application number: 25217328.1
(22) Date of filing: 20.11.2025
(51) Int. Cl.: H01S 5/026, H01S 5/12, H01S 5/50, H01S 5/10, H01S 5/028

(54) **LASER STRUCTURE**

(30) Priority: 27.03.2025 US 202563778522 P
(71) Applicant: II-VI Delaware, Inc., Wilmington, DE 19890 (US)
(72) Inventor: Zibik, Evgeny, Wilmington, 19890 (US); Maineult, Wilfried Nicolas Sébastien, Wilmington, 19890 (US)
(74) Representative: Maikowski & Ninnemann Patentanwälte Partnerschaft mbB

(57) **Abstract**

A laser structure includes a substrate including front and back facets and a waveguide formed thereon, the waveguide includes first and second arms extending in spaced relation between the front and back facets. The first arm includes a distributed feedback (DFB) laser and/or a semiconductor optical amplifier (SOA) and the second arm includes a SOA. At, proximate to, or adjacent the front facet, first ends of the first and second arms are spaced from each other by a first distance (d1) and an anti-reflective coating is disposed over at least the first ends of the first and second arms. At, proximate to, or adjacent the back facet, second ends of the first and second arms are spaced from each other by a second distance (d2). The laser structure is configured or includes additional structure whereupon light propagating in the first arm is coupled to the second arm.

## Description

### BACKGROUND

### 1) Field

The present disclosure relates to a laser structure or structure and, more particularly, to a laser structure that includes a first arm that includes a master oscillator (MO), such as distributed feedback (DFB) laser, and/or a first semiconductor optical amplifier (SOA) and a second arm that includes a second SOA. The laser structure is configured or includes additional structure whereupon light propagating in the first arm is coupled to the second arm.

### 2) Background

A prior art laser structure in the nature of an integrated semiconductor radiation generating device is disclosed in U.S. Patent No. 4,744,089 (hereinafter "the '089 patent") which is incorporated herein by reference in its entirety. This integrated semiconductor radiation generating device includes distributive feedback laser diode means including a first active region, wherein a laser beam is generated, and optical power amplifier means optically coupled straight, inline, or end-to-end to said distributed feedback laser diode means and having an entrance width substantially equal to and coplanar with the exit of said distributed feedback laser diode means. The optical power amplifier means includes a second active region for expanding and amplifying said laser beam prior to emission from said power amplifier means. A means is connected to said distributive feedback laser diode means and said optical power amplifier means for supplying pumping current to each independently of the other.

It would be desirable, however, to have a laser structure that is shorter in length and/or more compact than the prior art laser structure disclosed in the '089 patent.

### SUMMARY

Disclosed is a laser structure comprising a substrate comprising a front facet, a back facet, and a cavity or waveguide formed on or in the substrate, the cavity or waveguide comprises a first arm extending between the front facet and the back facet of the substrate and a second arm extending between the front facet and a back facet of the substrate, with at least a section of the first arm and a section of the second arm are disposed in spaced side-by-side relation to each other, wherein: the first arm includes a distributed feedback (DFB) laser or a semiconductor optical amplifier (SOA); the second arm includes a SOA; at, proximate to, or adjacent the front facet, first ends of the first and second arms are spaced from each other by a first distance (d1) and an anti-reflective coating is disposed over at least the first ends of the first and second arms; and at, proximate to, or adjacent the back facet, second ends of the first and second arms are spaced from each other by a second distance (d2).

Also disclosed is a laser structure comprising: a substrate; a cavity or waveguide disposed or formed on the substrate, the cavity or waveguide includes a first arm comprising a distributed feedback laser (DFB) or a first semiconductor optical amplifier (SOA) and a second arm comprising a second semiconductor optical amplifier (SOA), wherein at least a section of the first arm and at least a section of the second arm are disposed in spaced side-by-side relation to each other; and means for coupling light propagating in the first arm to the second arm, wherein the light propagating in the first arm is produced by the DFB or is input into the first arm from a laser external to the substrate.

### BRIEF DESCRIPTION OF THE DRAWINGS

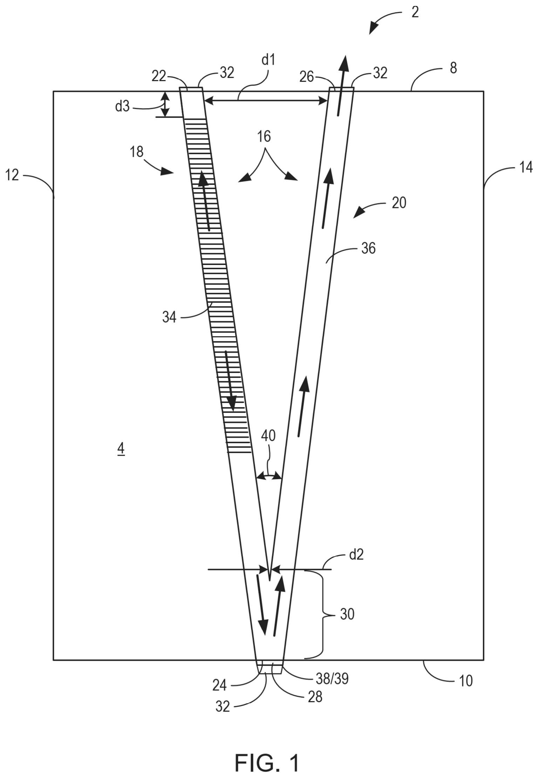

Figs. 1-10 are different example laser structures in accordance with the principles of the present disclosure.

### DETAILED DESCRIPTION

Various non-limiting embodiments will now be described with reference to the accompanying figures where like reference numbers correspond to like or functionally equivalent elements or features.

As used herein, spatial, or directional terms, such as "left", "right", "inner", "outer", "above", "below", "top side", "bottom side", and the like, relate to the disclosure as it is shown in the drawing figures. However, it is to be understood that the disclosure can assume various alternative orientations and, accordingly, such terms are not to be considered as limiting. Further, as used herein, all numbers expressing dimensions, physical characteristics, processing parameters, quantities of ingredients, reaction conditions, and the like, used in the specification and claims are to be understood as being modified in all instances by the term "approximately" or "about". Accordingly, unless indicated to the contrary, the numerical values set forth in the following specification and claims may vary depending upon the desired properties sought to be obtained by the present disclosure.

At the very least, and not as an attempt to limit the application of the doctrine of equivalents to the scope of the claims, each numerical value should at least be construed in light of the number of reported significant digits and by applying ordinary rounding techniques. Moreover, all ranges disclosed herein are to be understood to encompass the beginning and ending range values and any and all subranges subsumed therein. For example, a stated range of "1 to 10" should be considered to include any and all subranges between (and inclusive of) the minimum value of 1 and the maximum value of 10; that is, all subranges beginning with a minimum value of 1 or more and ending with a maximum value of 10 or less, e.g., 1 to 3.3, 4.7 to 7.5, 5.5 to 10, and the like. "A" or "an" refers to one or more.

As used herein, "coupled", "coupling", and similar terms refer to two or more elements that are joined, linked, fastened, connected, put in communication, or otherwise associated (e.g., mechanically, electromagnetically, fluidly, optically) with one another. In various examples, the elements may be associated directly or indirectly. As an example, element A may be directly associated with element B. As another example, element A may be indirectly associated with element B, for example, via another element C. It will be understood that not all associations among the various disclosed elements are necessarily represented. Accordingly, couplings other than those depicted in the figures may also exist.

As used herein, the phrase "at least one of", when used with a list of items, means different combinations of one or more of the listed items may be used and only one of each item in the list may be needed. For example, "at least one of item A, item B, and item C" may include, without limitation, item A or item A and item B. This example also may include item A, item B, and item C, or item B and item C. In other examples, "at least one of" may be, for example, without limitation, two of item A, one of item B, and ten of item C; four of item B and seven of item C; and other suitable combinations.

With reference to Fig. 1, a laser structure or structure 2 in accordance with the principles of the present disclosure comprises a substrate or body 4 that may be formed of a suitable semiconductor material and which may include, in the illustrated orientation, a front facet 8 at the top or top side, a back facet 10 at the bottom or bottom side, a left side 12, and a right side 14. Examples of a suitable semiconductor material may include, without limitation: GaAs, InAlGaAs, InP, InGaAsP, AlGaAsP, InAs, GaN, AlN, InGaN, and AlGaN. In this disclosure, the terms "laser structure 2" and "structure 2" may be used interchangeably.

Formed on or in the substrate 4 is a folded or V-shaped master oscillator (MP) power amplifier (PA) or MOPA 16 that includes a first arm, part, or section 18 proximate or adjacent the left side 12 that extends between the front facet 8 and the back facet 10 of the substrate 4 and a second arm, part, or section 20 proximate or adjacent the right side 14 that also extends between the front facet 8 and the back facet 10 of the substrate 4. In an example, the first and second arms 18 and 20 may be straight. Each arm 18 and 20 of the MOPA 16 may support a single optical transverse mode and may comprise an index or gain guided waveguide, a ridge waveguide, a trench waveguide, or a buried waveguide. Herein, the terms "MOPA", "cavity" and "waveguide", and the like may be used interchangeably.

The MOPA 16 may contain additional features, not shown in Fig.1, for example, to enhance reliability. For example, the MOPA 16 might have unpumped sections next to the front facet 8 and back facet 10 of the substrate 4 in order to prevent current flow close to the ends 22, 24, 26 and 28 of the first and second arms 18 and 20 of the MOPA 16. Moreover, the ends 22, 24, 26 and 28 may be passivated. Both unpumped section and passivation may suppress non-radiative carrier recombination on or at the ends 22, 24, 26 and 28 and hence prevent the catastrophic mirror damage (CMD).

Herein, when used in connection with reference number 22, the terms "first end" of the first arm 18 and "MO front facet" may be used interchangeably; when used in connection with reference number 24, the terms "second end" of the first arm 18 and "MO back facet" may be used interchangeably; when used in connection with reference number 26, the terms "first end" of the second arm 20 and "PA front facet" may be used interchangeably; and when used in connection with reference number 28, the terms "second end" of the second arm 20 and "PA back facet" may be used interchangeably.

In the example shown in Fig. 1, the first arm 18 may comprise the master oscillator (MO) part of the MOPA 16 and may include the first end or MO front facet 22 at or contiguous with the front facet 8 and the second end or MO back facet 24 at or contiguous with the back facet 10. The second arm 20 may comprise the power amplifier (PA) part of the MOPA 16 and may include a first end or PA front facet 26 at or contiguous with the front facet 8 and a second end or PO back facet 28 at or contiguous with the back facet 10. As shown in Fig. 1, at, proximate to, or adjacent the back facet 10 of the substrate 4, the MO back facet 24 and the PA back facet 28 of the first and second arms 18 and 20 of the MOPA 16 may converge and overlap to define an enlarged part or coupling region 30 of the MOPA 16.

At the top or front facet 8 of the substrate 4, the first end or MO front facet 22 of the first arm 18 and the first end or PA front facet 26 of the second arm 20 of the MOPA 16 may be spaced from each other by a first distance d1. An optical coating 32, such as an anti-reflective (AR) coating, may be disposed over the entirety of the front facet 8 of the substrate 4 or, as shown in Fig. 1, at least over the MO front facet 22 of the first arm 18 and the PA front facet 26 of the second arm 20 of the MOPA 16.

Proximate to or adjacent the back facet 10 of the substrate 4, the first and second arms 18 and 20 of the MOPA 16 may converge whereupon, above the enlarged part or coupling region 30 of the MOPA 16, the first and second arms 18 and 20 of the MOPA 16 may be spaced from each other by a second distance d2 that is less than the first distance d1. In an example, where the first and second arms 18 and 20 of the MOPA 16 converge to form the enlarged part or coupling region 30 of the MOPA 16, the second distance d2 may become zero. In an example, an angle 40 between the first and second arms 18 and 20 of the MOPA 16 above the enlarged part or coupling region 30 may be between 1° - 20°. In the example shown in Fig. 1, the first and second arms 18 and 20 of the MOPA 16 may form or define a "folded waveguide" having the form of V. In an example, the MOPA 16 may be angled with respect to the normal of front facet 8 and/or the back facet 10 of the substrate 4 by a half of angle 40.

A means 38 for causing light to propagate in the second arm 20 of the MOPA 16 based on light propagating in the first arm 18 of the MOPA 16 may be disposed over the entirety of the back facet 10 of the substrate 8 or, as shown in Fig. 1, at least over the end of the enlarged part or coupling region 30 at the back facet 10 of the substrate 8. Herein, the means 38 for causing light to propagate in the second arm 20 based on light propagating in the first arm 18 may also be referred to as a means for coupling light propagating in the first arm 18 to the second arm 20.

In an example, the means 38 for causing light to propagate in the second arm 20 of the MOPA 16 based on light propagating in the first arm 18 of the MOPA 16 may comprise a reflective optical coating 39 disposed over at least the portion of the back facet 10 of the substrate 8 where the MO back facet 24 and the PO back facet 28 of the first and second arms 18 and 20 of the MOPA 16 converge or overlap to form a combined facet 24/28 at the end of the enlarged part or coupling region 30 at the back facet 10 of the substrate 8. In an example, the reflective optical coating 39 may be >80% reflective and may cause light propagating in the first arm 18 of the MOPA 16 toward the combined facet 24/28 at the back facet 10 of the MOPA 16 to be reflected into the second arm 20 of the MOPA 16. In an example, the first arm 18 of the MOPA 16 may comprise a master oscillator (MO) in the form of a distributed feedback (DFB) laser 34 while the second arm 20 of the MOPA 16 may comprise a power amplifier (PO) in the form of a semiconductor optical amplifier (SOA) 36. DFB lasers, SOAs, their constructions and their operations are well known in the art and will not be described further herein except as necessary for an understanding of the present disclosure. In an example, the DFB laser 34 may include first, second, third, and higher order distributed feedback gratings. In an example, these distributed feedback gratings may have a uniform period or may be apodised. In an example, a uniform DFB grating may include a phase shift area, which helps to redistribute the optical power inside of the DFB laser 34 and hence prevent mode switching. It is known in the art that a DFB laser 34 with a π/2 phase shift region in the middle and AR-AR mirror coatings on opposite ends exhibit stable single longitudinal mode emission.

In use of the structure 2 shown in Fig. 1, a suitable AC, DC, or pulsed electrical bias may be applied (from an external electrical source - not shown) to the DFB laser 34 to cause the DFB laser 34 to produce laser light that propagates back and forth along the length of the DFB laser 34 while being amplified and escapes the DFB laser 34. The laser light coming from the end of the DFB laser 34 that faces the back facet 10 propagates to and is reflected by the reflective optical coating 39 to the SOA 36.

The same or another suitable AC, DC, or pulsed electrical bias may be applied (from the same or a different external electrical source - not shown) to the SOA 36. The DFB laser 34 and the SOA 36 may share the same contact pads (not shown) and hence the same electrical bias may be applied simultaneously from the same external electrical source to the DFB laser 34 and the SOA 36. Alternatively, the contact pads (not shown) of the DFB laser 34 and the SOA 36 may be separated/isolated, whereupon the DFB laser 34 and the SOA 36 may be electrically biased independently from different external electrical sources. In response to the electrical bias applied thereto, the SOA 36 may, in a manner known in the art, amplify the reflected laser light and output thus amplified laser light via the PA front facet 26 of the second arm 20 of the MOPA16.

In an example, the combination of the AR coatings 32 on the MO and PA front facets 22 and 26 of the first and second arms 18 and 20 of the MOPA 16 and the angle 40 between the first and second arms 18 and 20 of the MOPA 16 avoids or prevents light from being reflected back into the first and second arms 18 and 20 of the MOPA 16 from the MO and PA front facets 22 and 26. In an example, the DFB laser 34 may include a π/2 phase shift region that, in combination with the optical coatings 32 on the MO front facet 22 of the first arm 18 and the combined facet 24/28 of the MOPA 16, may produce a single longitudinal mode emission which may be amplified by the SOA 36. Accordingly, laser light escaping the PA front facet 26 of the second arm 20 of the MOPA 16 (that includes the SOA 36) may be significantly more intense compared to the laser light escaping the MO front facet 22 of the first arm 18 of the MOPA16 (that includes the DFB laser 34) and hence may be used in various applications where high power single longitudinal and transverse mode light is required, e.g. silicon photonics, fiber lasers or amplifiers, 3D sensing, and so on. Light escaping from the MO front facet 22 of the first arm 18 of the MOPA 16 (that includes the DFB laser 34) may be used in combination with a photodiode (not shown) to monitor the operation of the MOPA 16.

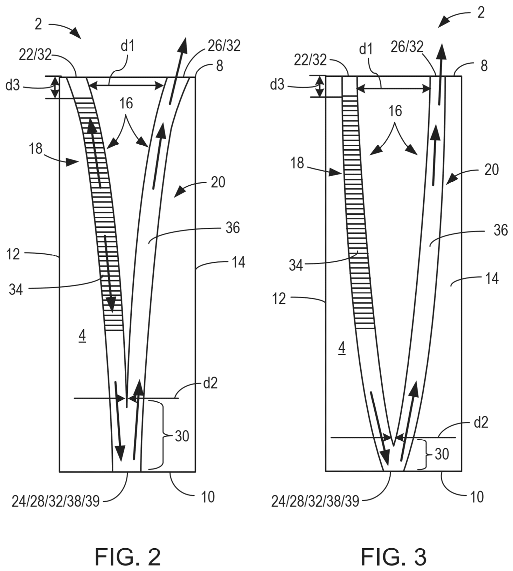

With reference to Fig. 2 and with continuing reference to Fig. 1, another example structure 2 in accordance with the principles of the present disclosure may be similar to and operate in the same manner as the example structure 2 shown in Fig. 1 with at least the following exception: in Fig. 2, the first arm 18 of the MOPA 16 approaching the front facet 8 from the back facet 10 arcs or curves away from the second arm 20 of the MOPA 16 (toward the left side 12 of the substrate 4) and the second arm 20 of the MOPA 16 approaching the front facet 8 from the back facet 10 arcs or curves away from the first arm 18 of the MOPA 16 (toward the right side 14 of the substrate 4). Stated differently, progressing from the back facet 10 to the front facet 8 of the substrate 4, the first and second arms 18 and 20 of the MOPA 16 arc, curve, or diverge away from each other with the convex sides of the first and second arms 18 and 20 facing each other and with the concave sides of the first and second arms 18 and 20 facing away each other.

With reference to Fig. 3 and with continuing reference to Fig. 1, another example structure 2 in accordance with the principles of the present disclosure may be similar to and operate in the same manner as the example structure 2 shown in Fig. 1 with at least the following exception: in Fig. 3, approaching the front facet 8, the first arm 18 of the MOPA 16 arcs or curves toward the second arm 20 of the MOPA 16 and the second arm 20 of the MOPA 16 arcs or curves toward the first arm 18 of the MOPA 16. Stated differently, approaching the front facet 8 of the substrate 4, the first and second arms 18 and 20 of the MOPA 16 arc, curve, or converge with the concave sides of the first and second arms 18 and 20 facing each other and with the convex sides of the first and second arms 18 and 20 facing away each other.

In the examples shown in Figs. 1-3, each of the MO and PA front facets 22 and 26 of the first and second arms 18 and 20 of the MOPA 16 may intersect the front facet 8 of the substrate 4 at an angle between 0° and 20°. However, this is not to be construed as limiting the present disclosure as other angles of intersection between each the MO and PA front facets 22 and 26 of the first and second arms 18 and 20 of the MOPA 16 and the front facet 8 of the substrate 4 are envisioned. To this end, the largest angle, e.g., 20°, may be limited by total internal reflection, inasmuch as laser light needs to escape the MOPA 16. Moreover, each MO and PA front facet 22 and 26 may intersect the front facet 8 of the substrate 4 at a different angle. Furthermore, adjacent the front facet 8 of the substrate 4, the end of the DFB laser 34 may be spaced from the front facet 8 a distance d3. Distance d3 may be in the range of 0 to a few um, depending on the length of a first arm 18 of the waveguide 16 and design requirements.

Each MOPA 16 disclosed herein may have first and/or second arms 18 and/or 20, each of which may be straight, arched, curved, or some combination thereof. However, this is not to be construed as limiting since it is envisioned that the first arm 18 of each MOPA 16 may have any shape as may be deemed suitable and/or desirable for an application. Similarly, the second arm 20 of each MOPA 16 may have any shape as may be deemed suitable and/or desirable for the application. Moreover, the shapes (straight, arched, curved, or some combination thereof) of each first arm 18 and each second arm 20 may be independent of each other. Accordingly, the shape (straight, arched, curved, or some combination thereof) of the first arm 18 and/or the second arm 20 of each MOPA 16 disclosed herein is not to be construed in a limiting sense.

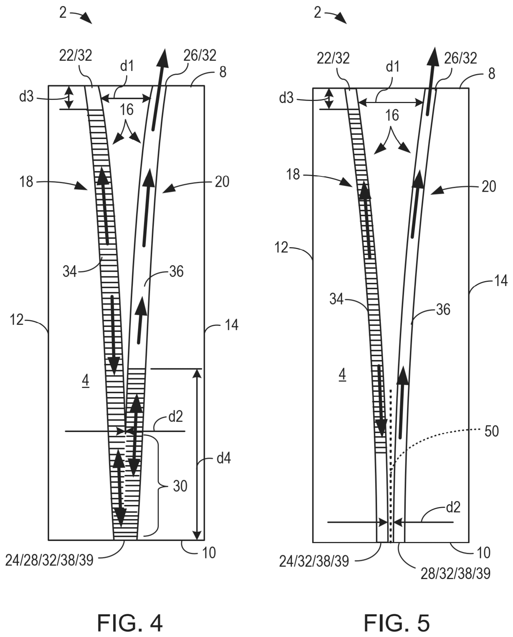

With reference to Fig. 4 and with continuing reference to all previous figures, another example structure 2 in accordance with the principles of the present disclosure may be similar to and operate in the same manner as the example structure 2 shown in Fig. 1 or 2 with at least the following exception: in Fig. 4, the DFB laser 34 may extend in the first arm 18 of the MOPA 16 to the back facet 10 and from there the DFB laser 34 may also extend a distance d4 in the second arm 20 of the MOPA 16 toward the front facet 8. In this example, the length of the SOA 36, as a function of the distance between the front facet 8 and back facet 10, may be shorter than the length of the SOAs 36 in previous examples.

In this example, laser light produced by the DFB laser 34 propagates back and forth along the length of the DFB laser 34 in both the first and second arms 18 and 20 of the MOPA16, with the laser light being reflected by the reflective optical coating 39 when propagating from the first arm 18 of the MOPA16 to the second arm 20 of the MOPA 16, and vice versa. Laser light escaping the end of the DFB laser 34 in the second arm 20 of the MOPA 16 that faces the front facet 8 passes through the SOA 36 which, in a manner known in the art, amplifies the laser light and outputs thus amplified laser light via the PA front facet 26 of the second arm 20 of the MOPA 16.

With reference to Fig. 5 and with continuing reference to all previous figures, another example structure 2 in accordance with the principles of the present disclosure may be similar to and operate in the same manner as the example structure 2 shown in Fig. 1 or 2 with at least the following exception: in Fig. 5 the MO back facet 24 of the first arm 18 of the MOPA 16 and the PA back facet 28 of the second arm 20 of the MOPA16 may be spaced from each other by a distance d2, i.e., the first and second arms 18 and 20 of the MOPA 16 do not converge and overlap to define the enlarged part 30 of the MOPA 16 including the combined facet 24/28 shown in the previous examples. In this example, optical coupling of laser light between the first and second arms 18 and 20 of the MOPA 16 may occur via evanescent coupling whereupon laser light propagating in the first arm 18 of the MOPA 16 excites, via evanescent coupling, laser light in the second arm 20 of the MOPA 16 at, proximate to, or adjacent the back facet 10.

In the example structure 2 shown in Fig. 5, to ensure effective or complete transfer of light from the first arm 18 of the MOPA 16 to the second arm 20 of the MOPA 16, the length of the MOPA 16 where evanescence coupling occurs and the distance d2 may be properly designed. In an example, there may be two options to realize this evanescence coupling, namely: (1) a directional coupling or (2) a contra-directional coupling. In an example of the directional coupling, the first and second arms 18 and 20 of the MOPA 16 may be similar, whereupon light transfer occurs when the propagation constant of the light in both the first and second arms 18 and 20 of the MOPA 16 is equal. In an example of contra-directional coupling, a grating 50 (shown in phantom in Fig. 5) may be included between the first and second arms 18 and 20 of the MOPA 16 for modulation of the shape of the first and/or second arms 18 and/or 20 of the MOPA 16. The coupling may now be deemed a periodic function that allows coupling with propagation constants of opposite signs. Nevertheless, the phase matching conditions may be offset by 2*pi/Lambda (where Lambda is the period of modulation of the shape of the grating 50), whereupon the first and second arms 18 and 20 of the MOPA 16 may not be identical.

The SOA 36 amplifies the laser light excited by evanescent coupling in the second arm 20 of the MOPA 16 at, proximate to, or adjacent the back facet 10 and outputs the excited laser light via the PA front facet 26 of the second arm 20 of the MOPA 16.

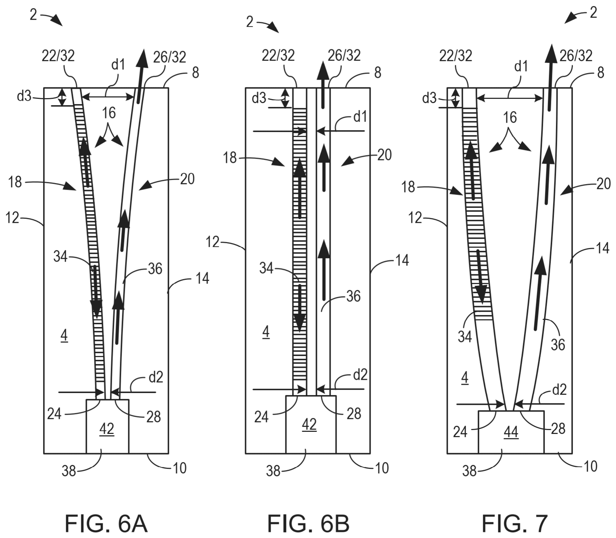

With reference to Figs. 6A-6B, other example structures 2 in accordance with the principles of the present disclosure may be similar to and operate in the same manner as the example structure 2 shown in Fig. 1 with at least the following exception: in Figs. 6A-6B, the MO and PA back facets 24 and 28 of the first and second arms 18 and 20 of the MOPA 16 may terminate in a multi-mode interference coupler (MMI) 42. In this example, the MMI 42 may comprise the means 38 for causing light to propagate in the second arm 20 of the MOPA 16 based on light propagating in the first arm 18 of the MOPA 16.

In the example structures 2 shown in Figs. 6A-6B, laser light produced by the DBF laser 34 propagates back and forth along the length of the DFB laser 34, escapes the MO back facet 24 of the DFB laser 34, and enters the MMI 42. The MMI 42, in a manner known in the art, may excite in the laser light received from the DFB laser 34 spatial modes that interfere constructively and destructively as they propagate, creating periodic interference patterns. In the MMI 42, these interference patterns may form "images" of the laser light received by the MMI 42 from the DFB laser 34, which images may be output by the MMI 42 to the PA back facet 28 of the second arm 20 of the MOPA 16 and, hence, to the SOA 36. The SOA 36 may, in a manner known in the art, amplify the laser light received from the MMI 42 and output thus amplified laser light via the PA front facet 26 of the second arm 20 of the MOPA 16.

In Fig. 6A, distance d1 between the first and second arm 18 and 20 of the MOPA 16 at, proximate to, or adjacent the front facet 8 may be greater than a distance d2 between the first and second arms 18 and 20 of the MOPA 16 at, proximate to, or adjacent the MMI 42, whereupon the first and second arms 18 and 20 of the MOPA 16 have the shape of a V. In Fig. 6A, the first and second arms 18 and 20 of the MOPA 16 may arc, curve, or diverge away from each other with the convex sides of the first and second arms 18 and 20 facing each other and with the concave sides of the first and second arms 18 and 20 facing away each other. In Fig. 6B, distance d1 and d2 may be the same, whereupon the first and second arms 18 and 20 of the MOPA 16 may be parallel to each other. In an example, distances d1 and d2 in Figs. 6A and 6B are desirably large enough to avoid or prevent evanescence coupling between laser light propagating in the first and second arms 18 and 20 of the MOPA 16. Moreover, the shapes of the first and second arms 18 and 20 of the MOPA 16 shown in Figs. 6A-6B are not to be construed in a limiting sense.

With reference to Fig. 7, another example structure 2 in accordance with the principles of the present disclosure may be similar to and operate in the same manner as the example structure 2 shown in Fig. 3 with at least the following exception: in Fig. 7, the MO and PA back facets 24 and 28 of the first and second arms 18 and 20 of the MOPA 16 may terminate in a subwavelength meta-structure forming a nano lens 44, such as a one-dimensional GRIN lens that is known in the art, that conjugates or combines the MO and PA back facets 24 and 28 through the nano lens 44. In this example, the nano lens 44 may comprise the means 38 for causing light to propagate in the second arm 20 of the MOPA 16 based on light propagating in the first arm 18 of the MOPA 16.

In the example structure 2 shown in Fig. 7, laser light produced by the DBF 34 propagates back and forth along the length of the first arm 18, escapes the MO back facet 24, and enters the nano lens 44. The nano lens 44 may reflect the laser light received from the DFB laser 34 to the PA back facet 28 of the second arm 20 of the MOPA 16 and, hence, to the SOA 36 which may, in a manner known in the art, amplify the laser light received from the nano lens 44 and output thus amplified laser light via the PA front facet 26 of the second arm 20 of the MOPA 16.

In Fig. 7, approaching the front facet 8, the first and second arms 18 and 20 of the MOPA 16 arc, curve, or converge toward each other with the concave sides of the first and second arms 18 and 20 facing each other and with the convex sides of the first and second arms 18 and 20 facing away each other. However, the shapes of the first and second arms 18 and 20 of the MOPA 16 in Fig. 7 are not to be construed in a limiting sense.

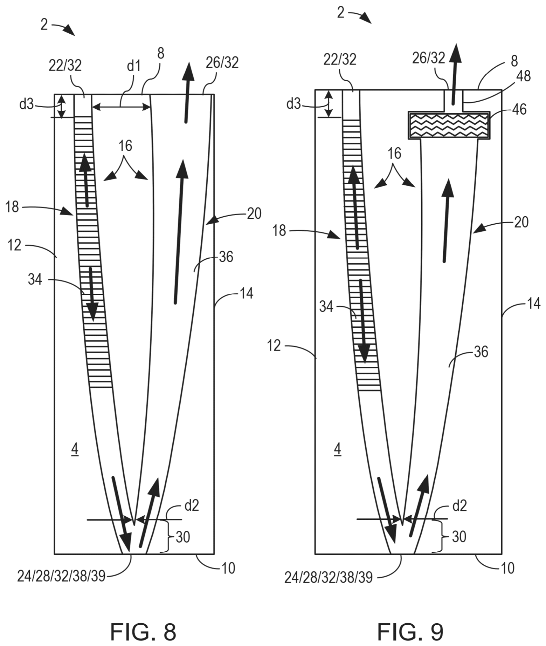

With reference to Fig. 8, another example structure 2 in accordance with the principles of the present disclosure may be similar to and operate in the same manner as the example structure 2 shown in Fig. 3 with at least the following exception: in Fig 8, from the PA back facet 28 toward the PA front facet 26 of the second arm 20 of the MOPA 16, the second arm 20 of the MOPA 16 may diverge defining an SOA 36 that is tapered and wider at, proximate to, or adjacent the front facet 8 and narrower at, proximate to, or adjacent the back facet 10. In an example, the wider part of the second arm may be at least twice as wide as the narrower part of the second arm.

This widening at, proximate to, or adjacent the front facet 8 may increase the amplified optical power inasmuch as the electrically pumped gain area of the SOA 36 is adiabatically increasing. The SOA 36 may remain single mode.

With reference to Fig. 9, another example structure 2 in accordance with the principles of the present disclosure may be similar to and operate in the same manner as the example structure 2 shown in Fig. 8 with at least the following exceptions: in Fig. 9, the structure 2 may include a spot size converter 46, e.g., a lens, between the PA front and back facets 26 and 28 of the second arm 20 of the MOPA 16, preferably proximate or adjacent the PA front facet 26 of the second arm 20 of the MOPA 16. In an example, the spot size converter 46 may be configured to reduce a cross-sectional size of a mode of the laser light propagating in the second arm 20 of the MOPA 16 and for outputting the laser light of reduced cross-sectional size mode to the PA front facet 26 of the second arm 20 of the MOPA 16.

In an example, between the spot size converter 46 and the PA front facet 26 of the second arm 20 of the MOPA 16, the MOPA 16 may include an optional section 48 having a smaller cross-section than the cross-section of the tapered part of the SOA 36 where the tapered part of the SOA terminates at the spot size converter 46. This optional section 48 may allow for propagation of the laser light of reduced cross-section from the spot size converter 46 to the PA front facet 26 of the second arm 20 of the MOPA 16.

The examples laser structures 2 shown in Figs. 8 and 9 may optionally include at their back facets 10 either the MMI 42 shown in Figs. 6A-6B or the nano lens 44 shown in Fig. 7.

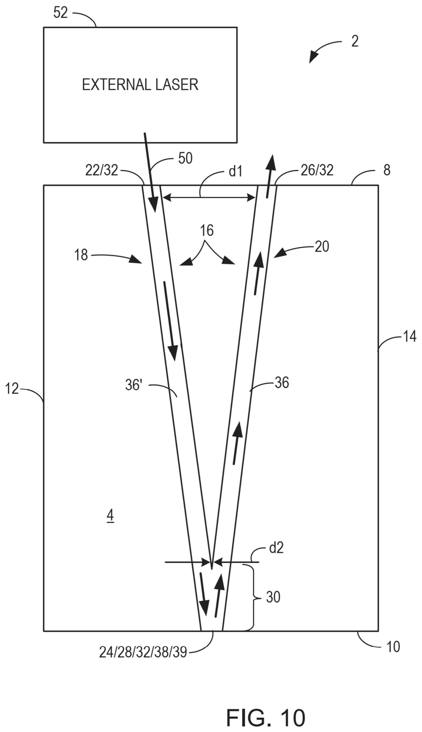

With reference to Fig. 10, another example structure 2 in accordance with the principles of the present disclosure may be similar in many respects to the example structure 2 shown in Fig. 1 with at least the following exceptions: in Fig. 10, the DFB laser 34 may be replaced by an SOA 36' and laser light 50 may be input into the SOA 36' from an external laser 52 via the first end 22 of the first arm 18 that includes the SOA 36'. In an example, the laser light 50 input into the first end 22 of the first arm 18 from the external laser 52 propagates through and is amplified by the SOA 36' which outputs the amplified laser light to the combined facet 24/28 of the first and second arms 18 and 20. At the combined facet 24/28 of the first and second arms 18 and 20, the means 38 for causing light to propagate in the second arm 20 based on light propagating in the first arm 18, e.g., the reflective optical coating 39, then causes the laser light to propagate from the second end 28 of the second arm 20 through the SOA 36 to the first end 26 of the second arm 20 where the laser light exits the second arm 20. Each SOA 36 and 36' described in this disclosure amplifies laser light propagating therethrough in a manner known in the art. The example structure 2 shown in Fig 10 may optionally include at the back facet 10 either the MMI 42 shown in Figs. 6A-6B or the nano lens 44 shown in Fig. 7. Alternatively, the first and second arms 18 and 20 and, hence, the second ends 24 and 28 of the example structure 2 shown in Fig 10 may be separated as shown, for example, in Fig. 5, whereupon SOAs 36 and 36' may be optically coupled using evanescence coupling as shown in Fig.5.

Other non-limiting examples or aspects of this disclosure are set forth in the following illustrative and exemplary numbered clauses
Clause 1: A laser structure or structure comprises: a substrate comprising a front facet, a back facet, and a waveguide formed on and/or in the substrate, the waveguide comprising a first arm extending between the front facet and the back facet of the substrate and a second arm extending between the front facet and a back facet of the substrate, wherein at least a part, portion, or section of a length of the first arm and a part, portion, or section of a length of the second arm are disposed in spaced side-by-side relation to each other. The first arm includes a distributed feedback (DFB) laser, such as, for example, without limitation, a single transverse mode laser, or a semiconductor optical amplifier (SOA). The second arm includes a SOA. At, proximate to, or adjacent the front facet, the first ends of the first and second arms are spaced from each other by a first distance (d1). An anti-reflective coating may be disposed over at least the first ends of the first and second arms. At, proximate to, or adjacent the back facet, second ends of the first and second arms are spaced from each other by a second distance.
Clause 2: The laser structure or structure of clause 1, wherein the second distance may be the same or less than the first distance and light propagating in the first arm may be coupled via evanescent coupling into the second arm.
Clause 3: The laser structure or structure of clause 1 or 2, further including, at, adjacent, or proximate the back facet, means for causing light to propagate in the second arm based on light propagating in the first arm.
Clause 4: The laser structure or structure of any one of clauses 1-3, wherein the means for causing light to propagate in the second arm based on light propagating in the first arm may comprise: a coupling region where the first and second arms converge and overlap and a reflective optical coating disposed over at least the second ends of the converged and overlapped first and second arms; or a directional coupling formed by the spacing between the first and second arms; or a contra-directional coupling comprising a grating disposed between the spaced first and second arms; or a multi-mode interference (MMI) coupler coupled to the second ends of the first and second arms; or a nano lens, e.g., a GRIN lens, coupled to the second ends of the first and second arms.
Clause 5: The laser structure or structure of any one of clauses 1-4, wherein the part, portion, or section of the length of the first arm and the part, portion, or section of the length of second arm may be disposed in spaced parallel relation to each other.
Clause 6: The laser structure or structure of any one of clauses 1-5, wherein: the part, portion, or section of the first arm and the part, portion, or section of the second arm may diverge away from each other; and at least one of the following: the part, portion, or section of the first arm may be straight or may be curved toward or away from the part, portion, or section of the second arm; and the part, portion, or section of the second arm may be straight or may be curved toward or away from the part, portion, or section of the first arm.
Clause 7: The laser structure or structure of any one of clauses 1-6, wherein the first and second arms may form a V-shape.
Clause 8: The laser structure or structure of any one of clauses 1-7, wherein, from the back facet toward the front facet, the second arm may taper whereupon the second arm at, proximate to, or adjacent the front facet may be at least twice as wide as the second arm at, proximate to, or adjacent the back facet.
Clause 9: The laser structure or structure of any one of clauses 1-8, further including in a path of the second arm a spot size converter for reducing a cross-sectional size of a mode output from the second arm at, proximate to, or adjacent the front facet.
Clause 10: The laser structure or structure of any one of clauses 1-9, wherein the parts, portions, or sections of the first and second arms may diverge away from each other at an angle between 1° and 20°.
Clause 11: The laser structure or structure of any one of clauses 1-10, wherein: an angle between the first end of the first arm and the front facet may be between 0° and 20°; or an angle between the first end of the second arm and the front facet may be between 0° and 20°; or both.
Clause 12: A laser structure or structure comprising: a substrate; a waveguide disposed or formed on the substrate, the waveguide including a first arm comprising a distributed feedback laser (DFB) or a first semiconductor optical amplifier (SOA) and a second arm comprising a second semiconductor optical amplifier (SOA), wherein at least a part, portion, or section of a length the first arm and at least a part, portion, or section of a length of the second arm are disposed in spaced side-by-side relation to each other; and means for coupling light propagating in the first arm to the second arm, wherein the light propagating in the first arm is produced by the DFB or is input into the first arm from a laser external to the substrate.
Clause 13: The laser structure or structure of clause 12, wherein the means for coupling light propagating in the first arm to the second arm may comprise: a coupling region where the first and second arms converge and overlap and a reflective optical coating disposed at, proximate to, or adjacent the coupling region for reflecting light propagating in the first arm to the second arm; or a directional coupling formed by a space between the first and second arms; or a contra-directional coupling comprising a grating disposed between a space between the first and second arms; or a multi-mode interference (MMI) coupler coupled to ends of the first and second arms; or a nano lens, e.g., a GRIN lens, coupled to ends of the first and second arms.
Clause 14: The laser structure or structure of clause 12 or 13, wherein the part, portion, or section of the length of the first arm and the part, portion, or section of the length of the second arm are disposed in spaced parallel relation to each other.
Clause 15: The laser structure or structure of any one of clauses 12-14, wherein the part, portion, or section of the length of the first arm and the part, portion, or section of the length of the second arm may diverge away from each other.
Clause 16: The laser structure or structure of any one of clauses 12-15, wherein: the part, portion, or section of the length of the first arm may be straight or may be curved toward or away from the part, portion, or section of the length of the second arm; or the part, portion, or section of the length of the second arm may be straight or may be curved toward or away from the part, portion, or section of the length of the first arm; or both.
Clause 17: The laser structure or structure of any one of clauses 12-16, wherein, along the length of the second arm, the second arm may taper whereupon at, proximate to, or adjacent a first end of the second arm, the second arm is at least twice as wide as the second arm at, proximate to, or adjacent a second end of the second arm.
Clause 18: The laser structure or structure of any one of clauses 12-17, wherein the second arm may include a spot size converter configured to reduce a cross-sectional size of a mode of light output from the second arm at, proximate to, or adjacent the first end of the second arm.
Clause 19: The laser structure or structure of any one of clauses 12-18, wherein the part, portion, or section of the length of the first arm and the part, portion, or section of the length of the second arm may diverge away from each other at an angle between 1° and 20°.

Although this disclosure has been described in detail for the purpose of illustration based on what is currently considered to be the most practical and preferred embodiments, it is to be understood that such detail is solely for that purpose and that the disclosure is not limited to the disclosed embodiments, but, on the contrary, is intended to cover modifications and equivalent arrangements that are within the spirit and scope of the appended claims. For example, it is to be understood that the present disclosure contemplates that, to the extent possible, one or more features of any embodiment can be combined with one or more features of any other embodiment.

## Claims

1. A structure comprising:
a substrate comprising a front facet, a back facet, and a waveguide formed on and/or in the substrate, the waveguide comprising a first arm extending between the front facet and the back facet of the substrate and a second arm extending between the front facet and a back facet of the substrate, with at least a section of the first arm and a section of the second arm disposed in spaced side-by-side relation to each other, wherein:
the first arm includes a distributed feedback (DFB) laser or a semiconductor optical amplifier (SOA);
the second arm includes a SOA;
at, proximate to, or adjacent the front facet, first ends of the first and second arms are spaced from each other by a first distance and an anti-reflective coating is disposed over at least the first ends of the first and second arms; and
at, proximate to, or adjacent the back facet, second ends of the first and second arms are spaced from each other by a second distance.

2. The structure of claim 1, wherein the second distance is the same or less than the first distance and light propagating in the first arm is coupled via evanescent coupling into the second arm.

3. The structure of claim 1, further including, at, adjacent, or proximate the back facet, means for causing light to propagate in the second arm based on light propagating in the first arm,
wherein the means for causing light to propagate in the second arm based on light propagating in the first arm preferably comprises:
a coupling region where the first and second arms converge and overlap and a reflective optical coating disposed over at least the second ends of the converged and overlapped first and second arms; or
directional coupling formed by the spacing between the first and second arms; or
contra-directional coupling comprising a grating disposed between the spaced first and second arms; or
a multi-mode interference (MMI) coupler coupled to the second ends of the first and second arms; or
a nano lens coupled to the second ends of the first and second arms.

4. The structure of claim 1, wherein the section of the first arm and the section of the second arm are disposed in spaced parallel relation to each other.

5. The structure of claim 1, wherein:
the section of the first arm and the section of the second arm diverge away from each other; and
at least one of the following:
the section of the first arm is straight or is curved toward or away from the section of the second arm; and
the section of the second arm is straight or is curved toward or away from the section of the first arm.

6. The structure of claim 5, wherein the first and second arms form a V-shape.

7. The structure of claim 5, wherein, from the back facet toward the front facet, the second arm tapers whereupon the second arm at, proximate to, or adjacent the front facet is at least twice as wide as the second arm at, proximate to, or adjacent the back facet,
preferably further including in a path of the second arm a spot size converter for reducing a cross-sectional size of a mode output from the second arm at, proximate to, or adjacent the front facet.

8. The structure of claim 5, wherein the section of the first arm and the section of the second arm diverge away from each other at an angle between 1° and 20°.

9. The structure of claim 1, wherein:
an angle between the first end of the first arm and the front facet is between 0° and 20°; or
an angle between the first end of the second arm and the front facet is between 0° and 20°; or
both.

10. A structure comprising:
a substrate;
a waveguide disposed or formed on the substrate, the waveguide including a first arm comprising a distributed feedback laser (DFB) or a first semiconductor optical amplifier (SOA) and a second arm comprising a second semiconductor optical amplifier (SOA), wherein at least a section of the first arm and at least a section of the second arm are disposed in spaced side-by-side relation to each other; and
means for coupling light propagating in the first arm to the second arm, wherein the light propagating in the first arm is produced by the DFB or is input into the first arm from a laser external to the substrate.

11. The structure of claim 10, wherein the means for coupling light propagating in the first arm to the second arm comprises:
a coupling region where the first and second arms converge and overlap and a reflective optical coating disposed at, proximate to, or adjacent the coupling region for reflecting light propagating in the first arm to the second arm; or
a directional coupling formed by a space between the first and second arms; or
a contra-directional coupling comprising a grating disposed between a space between the first and second arms; or
a multi-mode interference (MMI) coupler coupled to ends of the first and second arms; or
a nano lens coupled to ends of the first and second arms.

12. The structure of claim 10, wherein the section of the first arm and the section of the second arm are disposed in spaced parallel relation to each other.

13. The structure of claim 10, wherein the section of the first arm and the section of the second arm diverge away from each other.

14. The structure of claim 13, wherein:
the section of the first arm is straight or is curved toward or away from the section of the second arm; or
the section of the second arm is straight or is curved toward or away from the section of the first arm; or
both.

15. The structure of claim 13, wherein, along the length of the second arm, the second arm tapers whereupon at, proximate to, or adjacent a first end of the second arm, the second arm is at least twice as wide as the second arm at, proximate to, or adjacent a second end of the second arm,
wherein the second arm preferably includes a spot size converter configured to reduce a cross-sectional size of a mode of light output from the second arm at, proximate to, or adjacent the first end of the second arm, or
wherein the section of the first arm and the section of the second arm diverge away from each other at an angle between 1° and 20°.
